# EUROPEAN PATENT APPLICATION

(11) **EP 1 533 832 A1**
(43) Date of publication of application: **25.05.2005**
(21) Application number: 03733507.2
(22) Date of filing: 19.06.2003
(51) Int. Cl.: H01L 21/027, G03F 7/20, G21K 1/06

(54) **OPTICAL UNIT AND X-RAY EXPOSURE SYSTEM**

(30) Priority: 25.06.2002 JP 2002183798
(71) Applicant: Nikon Corporation, Tokyo 100-8331 (JP)
(72) Inventor: Kondo, Hiroyuki, Chiyoda-ku, Tokyo 100-8331 (JP); Murakami, Katsuhiko, Chiyoda-ku, Tokyo 100-8331 (JP)
(74) Representative: Volpert, Marcus
(86) International application number: PCT/JP2003/007815
(87) International publication number: WO 2004/001821

(57) **Abstract**

An optical unit of the present invention includes an X-ray optical device, an airtight container for housing the X-ray optical device in an airtight state, and valves or opening mechanisms which are fitted to an X-ray inlet and an X-ray outlet of the airtight container. Furthermore, an X-ray exposure system of the present invention includes an X-ray source for generating X-rays, an illumination optical system for irradiating X-rays from the X-ray source onto a mask, and an optical unit that houses an X-ray optical device which constitutes a projection optical system for projecting a pattern image formed on the mask onto a photosensitive substrate. In this X-ray exposure system, the optical unit includes an airtight container for housing the X-ray optical device in an airtight state, and valves or opening mechanisms are attached to an X-ray inlet and an X-ray outlet of the airtight container.

The optical unit and the X-ray exposure system of the present invention enable contamination of the optical device surfaces to be suppressed. As a result, deterioration in the reflectance of the optical device, and deterioration in the throughput of the exposure system can be suppressed.

## Description

### TECHNICAL FIELD

The present invention relates to an optical unit that houses X-ray optical devices and an X-ray exposure system that utilizes such an optical unit.

### BACKGROUND ART

Recently, as the demands have grown for even greater miniaturization of semiconductor integrated circuits, the need has arisen for further improvements in the resolving power of the optical system, which is limited by the diffraction limit for the light. One method of meeting this need has seen the ongoing development of a projection lithography technique that uses X-rays with shorter wavelengths (11 to 14 nm) than the conventionally used ultraviolet light (for example, see D. Tichenor, et al., SPIE 2437 (1995) 292). This technique is now known as EUV (Extreme Ultraviolet) lithography, and shows considerable promise as a technique capable of achieving a resolving power of less than 70 nm, a level that has been impossible to realize with conventional photolithography that uses light with a wavelength of approximately 190 nm.

Because all materials display strong absorption within the X-ray region, typical transmission-refraction type optical devices (such as lenses) cannot be used, and reflective mirrors formed from ultra thin film filters or multilayer films are used as the optical devices. Furthermore, because X-rays are also absorbed by air, the optical path must be placed in a state of vacuum. As a result, the X-ray mirrors and the like are housed inside a vacuum chamber that is evacuated down to a predetermined degree of vacuum by an evacuation device. As follows is a description of the structure of a conventional X-ray exposure system.

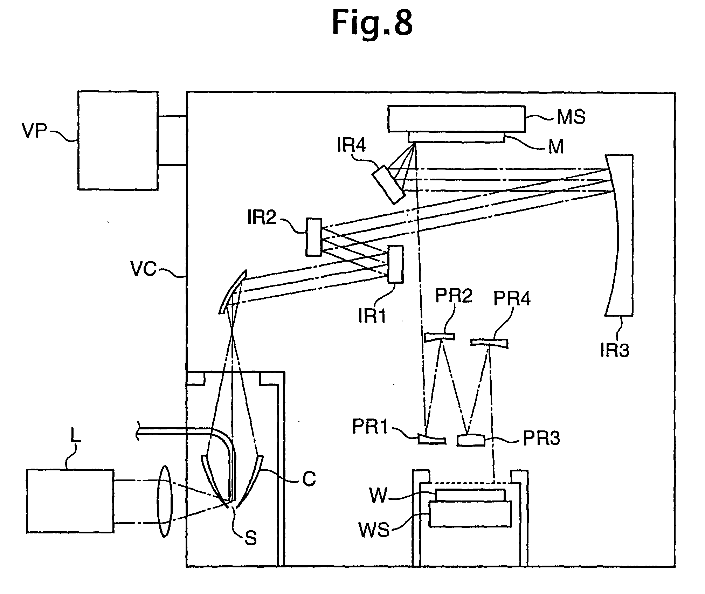

Fig. 8 is a schematic diagram showing the structure of a conventional X-ray exposure system. This X-ray exposure system includes, as its main components, an X-ray source S, a condenser C, an illumination optical system IR (including IR1, IR2, IR3, IR4, and the like), a stage MS for a mask M, a projection optical system PR (including PR1, PR2, PR3, and PR4), a stage WS for a wafer W, a vacuum chamber VC, and an evacuation system VP.

The X-ray source S uses a laser plasma source including a plasma excitation laser L, or a discharge plasma source or some other form of irradiated light. The illumination optical system IR includes a grazing incidence mirror for reflecting the X-ray beam which strikes the mirror surface at an oblique angle, multilayer film mirrors (IR1, IR2, IR3, and IR4) in which the reflective surface is formed from a multilayer film, and a filter that allows the transmission of only X-rays of a predetermined wavelength. This illumination optical system IR enables the surface of the mask M to be illuminated with an X-ray beam of a predetermined wavelength.

Because no materials exist that are transparent within the X-ray wavelength region, the mask M uses a reflective type mask instead of the conventional transmission type mask. The projection optical system PR includes a plurality (for example, 4 or 6) of multilayer film mirrors (PR1, PR2, PR3, and PR4). A circuit pattern formed on the mask M is imaged onto the resist-coated wafer W by the projection optical system, and thus transferred to the resist. Because the X-rays are attenuated by atmospheric absorption, the exposure operation is conducted with the entire optical path housed inside the vacuum chamber VC. The inside of this vacuum chamber VC is maintained at a predetermined degree of vacuum (for example, no more than 1x10⁻³ Pa) by the evacuation system VP.

In the X-ray exposure system shown in Fig. 8, the evacuation system VP is operated for maintaining the inside of the chamber during the exposure operation, so that the X-ray optical devices such as the multilayer film mirrors, and the like that constitute the projection optical system PR are arranged under vacuum. However, during assembly and adjustment of the exposure system the vacuum chamber is not under vacuum, meaning the X-ray optical devices are exposed to the outside atmosphere. Similarly, the inside of the vacuum chamber also needs to be opened to the atmosphere (leaked) during maintenance of the exposure system or replacement of the multilayer film mirrors, meaning the X-ray optical devices are, once again, exposed to the outside atmosphere. The outside atmosphere includes a variety of materials that can cause contamination (such as organic gases containing hydrocarbons), and contamination of the optical devices by these organic gases is a problem. A simple description of the mechanism that gives rise to contamination of the optical devices by such organic gases is presented below.

Organic gas molecules present in the outside air physically adsorb to the surfaces of the X-ray optical devices inside the exposure system. These organic gas molecules adsorbed to the surfaces of the optical devices undergo repeated desorption from, and adsorption to the surface, and on their own, do not grow into a thick layer. However, when the optical devices are irradiated with X-rays during the exposure operation, secondary electrons are generated from within the substrates of the optical devices, and these secondary electrons can cause decomposition of the adsorbed organic gas molecules, resulting in the accumulation of carbon contamination. Gas molecules are continuously decomposed in this manner, causing increased accumulation, and consequently a layer of carbon is formed on the surface of the optical devices, and the thickness of that carbon layer increases proportionally with the X-ray irradiation dose (see K. Boller et al., Nucl. Instr. and Meth., 208 (1983) 273).

As described above, if a carbon layer forms on the surface of an optical device such as a multilayer film mirror, then the reflectance of the optical device deteriorates. The air inside the type of clean room in which an exposure system is installed typically contains large quantities of organic gases that can cause contamination, and consequently when the optical device is exposed to the air during either assembly or maintenance of the system inside the clean room, the number of organic gas molecules that physically adsorb to the surface of the optical device is considerably large. As a result, when the optical device is subsequently irradiated with X-rays during the exposure operation, the thickness of the carbon layer formed on the surface of the optical device increases, causing a marked reduction in the reflectance of the optical device. As the reflectance of these optical devices decreases, the throughput for the X-ray exposure system deteriorates. In addition, exposure of an optical device to the outside air can also cause moisture in the air to adhere to the surface of the optical device, which increases the danger of difficulties in maintaining the degree of vacuum within the exposure system. Furthermore, if water that has adhered to the surface of an optical device is irradiated with X-rays, then the surface of the optical device can oxidize, causing a deterioration in the reflectance.

### DISCLOSURE OF INVENTION

The present invention takes the problems described above into consideration, with an object of providing an optical unit and an X-ray exposure system that are capable of suppressing the contamination of the surfaces of X-ray optical devices such as multilayer film mirrors.

In order to achieve this object, an optical unit according to the present invention includes an X-ray optical device, an airtight container for housing the X-ray optical device in an airtight state, and valves or openable and closable opening mechanisms which are attached to an X-ray inlet and an X-ray outlet of the airtight container.

In the present invention, the inside of the airtight container is preferably held under vacuum or a clean displacement gas atmosphere.

The aforementioned optical unit includes openable and closeable valves (or opening mechanisms) at both the X-ray inlet and the X-ray outlet of the airtight container. By closing these valves, the inside of the optical unit can be held under vacuum or a clean displacement gas atmosphere, meaning the quantity of organic gas molecules that physically adsorb to the surfaces of the X-ray optical devices such as multilayer film mirrors housed inside the optical unit can be reduced. Accordingly, by using this type of optical unit, contamination of the surfaces of the optical devices can be suppressed. Furthermore, by opening the valves in the optical unit, the X-ray inlet and X-ray outlet of the airtight container are opened, meaning absorption of X-rays by the airtight container can be prevented.

Furthermore, another optical unit according to the present invention includes an X-ray optical device, a holding unit for holding the X-ray optical device, an airtight container for housing the X-ray optical device and the holding unit in an airtight state, and valves or openable and closable opening mechanisms which are attached to an X-ray inlet and an X-ray outlet of the airtight container.

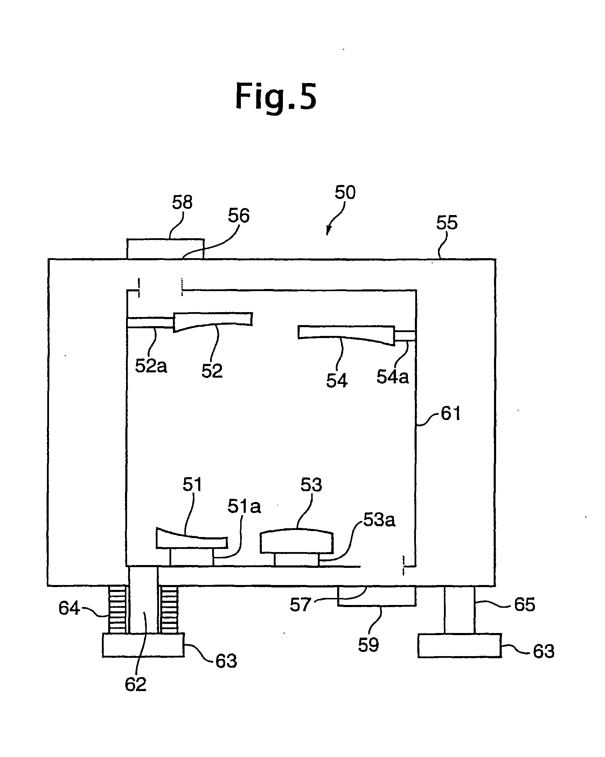

Typically, if the inside of the optical unit is evacuated down to a state of vacuum, then the atmospheric pressure from outside the optical unit causes distortion of the airtight container. As a result, deformation or positional displacement of the X-ray optical devices connected to the airtight container can occur. Accordingly, the optical unit described above includes a holding unit for holding the X-ray optical device independently of the airtight container, meaning any distortion of the airtight container is prevented from being transmitted to the holding unit. For example, as described below with reference to Fig. 5, the holding unit can be formed as a structure that is mechanically detached from the airtight container, and is installed independently on the exposure system. Accordingly, even when the inside of the airtight container is placed under vacuum, any distortion (deformation) of the airtight container is not transferred to the holding unit, meaning deformation or positional displacement of the X-ray optical device can be suppressed.

In the present invention, the aforementioned valves or openable and closable opening mechanisms are preferably composed of members that are transparent to ultraviolet light or visible light. This allows positional adjustment of the optical system such as the mirrors to be conducted using a simple laser beam or the like rather than X-rays, while the inside of the optical unit is held either under vacuum or a clean displacement gas atmosphere.

Furthermore, in the present invention, the airtight container is preferably provided with an exhaust port for evacuating gas from inside the airtight container, and a valve or opening mechanism that is connected to this exhaust port.

In addition, the present invention preferably also includes a position adjusting mechanism for adjusting the position and orientation of the X-ray optical device from outside the airtight container under normal atmospheric conditions. Such a mechanism enables the position and orientation of the X-ray optical device to be adjusted with the inside of the optical unit maintained either under vacuum or within a clean displacement gas environment.

In the present invention, the X-ray optical device is preferably the X-ray optical device that constitutes a projection optical system for projecting a pattern image formed on a mask onto a photosensitive substrate. In addition, the X-ray optical device preferably further includes a portion of an X-ray optical device that constitutes an illumination optical system for irradiating X-rays from an X-ray source onto the mask. Such a configuration enables the surface contamination of a large number of optical devices used in the X-ray projection exposure system to be suppressed.

In the present invention, even if the airtight container is not a strictly airtight structure, a substantially airtight structure can still be used. In other words, provided the conductance between the inside and the outside of the airtight container is lower than a certain level, a small amount of gas inflow and outflow is acceptable. In addition, in the present invention, the airtight container is preferably also provided with a thermoregulator.

An X-ray exposure system according to the present invention includes an X-ray source for generating X-rays, an illumination optical system for irradiating X-rays from the X-ray source onto a mask, and an optical unit that houses an X-ray optical device which constitutes a projection optical system for projecting a pattern image formed on the mask onto a photosensitive substrate, wherein the optical unit includes an airtight container for housing the X-ray optical device in an airtight state, and valves or openable and closable opening mechanisms are attached to an X-ray inlet and an X-ray outlet of the airtight container.

Furthermore, another X-ray exposure system according to the present invention includes an X-ray source for generating X-rays, an illumination optical system for irradiating X-rays from the X-ray source onto a mask, and an optical unit that houses an X-ray optical device which constitutes a projection optical system for projecting a pattern image formed on the mask onto a photosensitive substrate, wherein the optical unit includes a holding unit for holding the X-ray optical device and an airtight container for housing the X-ray optical device and the holding unit in an airtight state, and valves or openable and closable opening mechanisms are attached to an X-ray inlet and an X-ray outlet of the airtight container.

In the present invention, the aforementioned valves or openable and closable opening mechanisms are preferably composed of members that are transparent to ultraviolet light or visible light.

Furthermore, in the present invention, the airtight container is preferably provided with an exhaust port for evacuating gas from inside the airtight container, and a valve or opening mechanism that is connected to this exhaust port.

Furthermore, in the present invention, the airtight container preferably also houses a portion of the X-ray optical device that constitutes the illumination optical system.

In addition, the present invention preferably also includes a position adjusting mechanism for adjusting the position and orientation of the X-ray optical device from outside the airtight container under normal atmospheric conditions.

Furthermore, in the present invention, a thermoregulator for regulating the temperature of the optical unit is preferably provided outside the airtight container under normal atmospheric conditions. This enables the construction of the system to be simplified, meaning production costs can be kept to a minimum.

In addition, in the present invention, even if the airtight container is not a strictly airtight structure, a substantially airtight structure can still be used. In other words, provided the conductance between the inside and the outside of the airtight container is lower than a certain level, a small amount of gas inflow and outflow is acceptable.

### BRIEF DESCRIPTION OF THE DRAWINGS

Fig. 1 is a schematic structural diagram showing an optical unit according to an embodiment of the present invention;
Fig. 2 is a schematic structural diagram showing an evacuation device (such as a turbomolecular pump) fitted to the optical unit shown in Fig. 1;
Fig. 3 is a schematic structural diagram showing an X-ray exposure system according to an embodiment of the present invention, using the optical unit shown in Fig. 1;
Fig. 4 is a schematic structural diagram showing an X-ray exposure system according to another embodiment of the present invention, which also uses the optical unit shown in Fig. 1;
Fig. 5 is a schematic structural diagram showing an optical unit according to another embodiment of the present invention;
Fig. 6 is a schematic structural diagram showing an optical unit according to yet another embodiment of the present invention;
Fig. 7 is a schematic structural diagram showing the vicinity around the optical unit of an X-ray exposure system according to yet another embodiment of the present invention, which uses the optical unit shown in Fig. 6;
Fig. 8 is a schematic structural diagram showing a conventional X-ray exposure system; and
Fig. 9 is a schematic structural diagram showing a mirror position adjusting mechanism according to another embodiment of the present invention.

### DESCRIPTION OF THE REFERENCE SYMBOLS

- 10: optical unit
- 11, 12, 13, 14: multilayer film mirror
- 11a, 12a, 13a, 14a: holding mechanism
- 11b, 12b, 13b, 14b: mirror position adjusting mechanism
- 15: airtight container
- 16: X-ray inlet
- 17: X-ray outlet
- 18, 19: gate valve
- 20: cooling jacket
- 21: turbomolecular pump
- 22: pressure gauge
- 23: flange
- 30: X-ray exposure system
- 31: pressure gauge
- 32: mounting column
- 40: X-ray exposure system
- 41: first vacuum chamber
- 42: second vacuum chamber
- 43, 44: gate valve
- 45: thermoregulator
- 50: optical unit
- 51, 52, 53, 54: multilayer film mirror
- 51a, 52a, 53a, 54a: holding mechanism
- 55: airtight container
- 56: X-ray inlet
- 57: X-ray outlet
- 58, 59: gate valve
- 61: mirror holding unit
- 62: support member
- 63: support
- 64: bellows
- 65: support member
- 70: optical unit
- 71, 72, 73, 74: multilayer film mirror
- 71a, 72a, 73a, 74a: holding mechanism
- 75: airtight container
- 76: X-ray inlet
- 77: X-ray outlet
- 78, 79: opening mechanism
- 81: inflow slot
- 82: outflow slot
- 83: valve
- 84: filter
- 85: supply source (cylinder)
- 86: valve
- 87: pressure gauge
- 90: X-ray exposure system
- 91: gas supply pipe
- 92: feed-through flange
- 100: mirror
- 101: mirror platform
- 102: guide
- 103: partition
- 104: piezo device
- 105: return spring

### BEST MODE FOR CARRYING OUT THE INVENTION

Hereinafter, a description is given of embodiments of the invention with reference to the accompanying drawings.

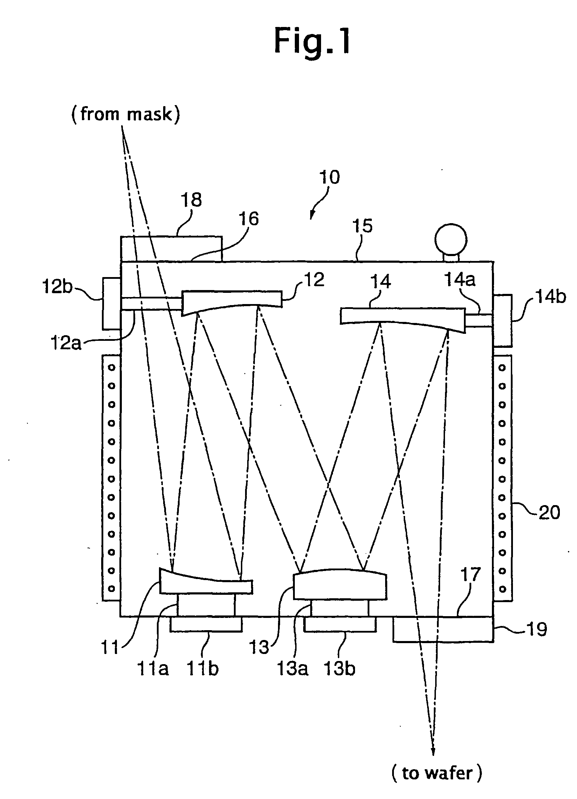

Fig. 1 is a schematic structural diagram showing an optical unit according to an embodiment of the present invention. This optical unit 10 includes an airtight container 15 that houses a plurality (4 in the case shown in Fig. 1) of multilayer film mirrors 11, 12, 13, and 14 that constitute a projection optical system. These multilayer film mirrors can use, for example, mirrors produced by forming a Mo/Si multilayer film or a Mo/Be multilayer film on top of a substrate. The multilayer film mirrors 11, 12, 13, and 14 are attached to the airtight container 15 via holding mechanisms 11a, 12a, 13a, and 14a, respectively. Each of these holding mechanisms 11a to 14a preferably includes a cushioning mechanism so that any distortion of the airtight container that occurs during evacuation of the airtight container 15 down to vacuum is not transmitted to the multilayer film mirrors 11 to 14. These cushioning mechanisms can use devices incorporating mirror clamps, plate spring mechanisms to enable thermal expansion relief, and piezo device-based position and orientation fine adjustment actuators.

In addition, the optical unit 10 is preferably provided with mirror position adjusting mechanisms 11b to 14b, so that the position and orientation of the multilayer film mirrors 11 to 14 can be adjusted with the inside of the optical unit 10 maintained under a state of vacuum. The mirror position adjusting mechanisms 11b to 14b enable positional displacements to be transmitted from outside the optical unit 10 (under normal atmospheric conditions) to inside the optical unit (which is under vacuum), thus realizing adjustment of the multilayer film mirrors.

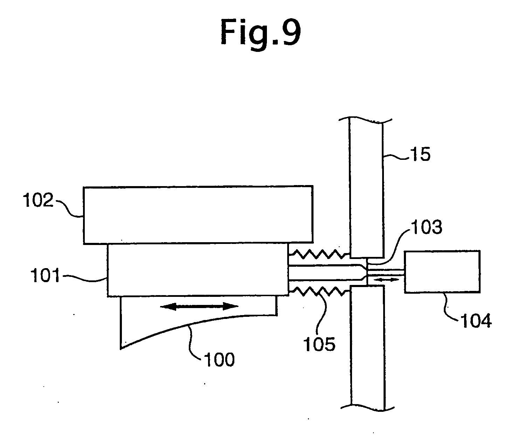

One possible example of the mirror position adjusting mechanisms 11b to 14b includes a partition 103 formed from a thin metal foil (for example, a thin sheet of stainless steel with a thickness of no more than 0.1 mm) as one portion of the airtight container 15, as shown in Fig. 9. A mirror 100 mounted on a mirror platform 101, and a guide 102 for guiding this mirror platform are provided on the inside of this partition, inside the airtight container 15. In addition, a piezo device 104 that faces the mirror platform 101 across the partition 103 is provided on the outside of the airtight container 15, and a return spring 105 that is fitted between the airtight container 15 and the mirror platform 101 in an energized state is provided to keep the mirror platform 101 held against the piezo device 104 at all times. Movement of the mirror 100 is achieved either by pushing the mirror platform 101 via the driving force of the piezo device 104, or by pulling the mirror platform 101 back using the compressive force of the return spring 105. In this manner, the position of the mirror platform 101 on which the mirror 100 is mounted can be pushed and pulled from a position outside the airtight container 15, or the atmospheric side, using a combination of the piezo device 104 and the return spring 105, thus enabling adjustments in the position of the multilayer film mirror.

These mirror position adjusting mechanisms can also use other mechanisms that utilize magnetism. In those cases where magnetism is used, an internal magnet is incorporated within the mirror holding mechanism or the like on the vacuum side of the unit, and an external magnet that magnetically couples with the internal magnet is provided in a position on the atmospheric side. Then, by moving the external magnet outside the container, this displacement is transmitted to the mirror holding mechanism containing the fixed internal magnet on the vacuum side of the container, thus achieving a positional adjustment of the multilayer film mirror.

In the above adjusting mechanisms, the gate valves 18 and 19 are preferably formed from members (such as glass) that are transparent to ultraviolet light or visible light. This allows positional adjustment of the optical system such as the mirrors to be conducted using a simple laser beam or the like rather than X-rays, while the inside of the optical unit 10 is maintained under vacuum.

The airtight container 15 is fabricated from a low thermal expansion material such as invar in order to suppress the occurrence of deformation or positional displacement of the multilayer film mirrors caused by expansion or contraction of the airtight container as a result of temperature variation. Furthermore, in order to minimize the level of out-gas expelled when the container is evacuated, both the inside and outside surfaces of the airtight container 15 are subjected to electrolytic polishing. In addition, a thermoregulator such as a water-cooling jacket 20 is preferably provided around the exterior of the airtight container 15 in order to enable regulation of the temperature of the optical unit 10.

The gate valves 18 and 19 are provided at the X-ray inlet 16 and the X-ray outlet 17 respectively of the airtight container 15. The gate valves 18 and 19 can use (commercially available) gate valves that can be opened and closed used a cylinder mechanism driven by compressed gas. By closing the gates valves 18 and 19, the inside of the optical unit 10 becomes a sealed structure. Furthermore, by opening the gate valves 18 and 19, the X-ray inlet 16 and the X-ray outlet 17 of the airtight container 15 can be opened.

An X-ray beam that has undergone reflection and diffraction off a mask positioned outside the optical unit 10 passes through the X-ray inlet 16 of the airtight container 15 and into the airtight container. This X-ray beam that has entered the airtight container 15 is reflected off the multilayer film mirrors 11 to 14, and then passes through the X-ray outlet 17 of the airtight container 15 and leaves the optical unit 10, where it is irradiated onto a photosensitive substrate (wafer) with a resist coating. This process enables the pattern image formed on the mask to be projected onto the wafer.

As follows is a description of one example of the procedure used when the optical unit 10 shown in Fig. 1 requires maintenance or adjustment. First, the gate valves 18 and 19 are closed. With the state of vacuum maintained, the optical unit 10 is removed from the exposure system.

The optical unit 10 is then transported to a maintenance room or the like which is maintained as a clean environment. Sufficient clean gas (such as dry N₂, dry He, or dry air) is injected into the optical unit to raise the internal pressure to atmospheric pressure, and the gate valves 18 and 19 are then opened, exposing the unit to the atmosphere for the first time. Following completion of the required maintenance or adjustments, the gate valves 18 and 19 are closed, and the inside of the optical unit is returned to a state of vacuum before re-installation in the exposure system.

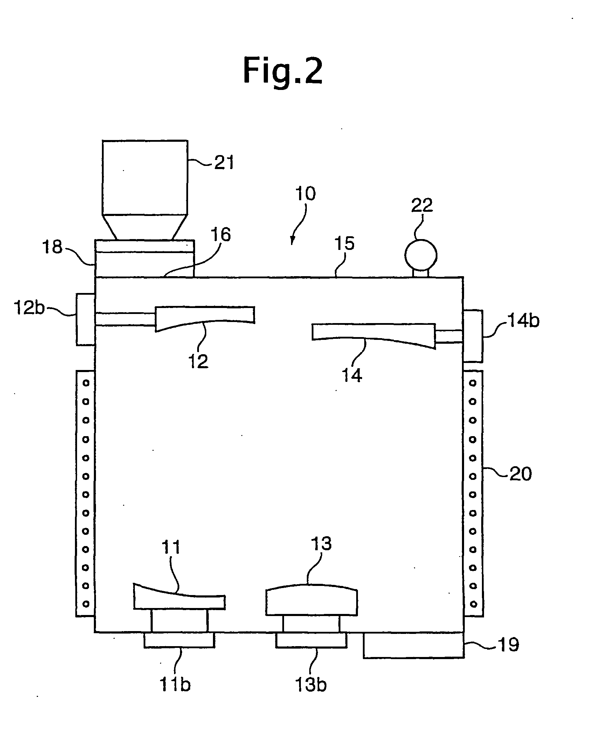

The evacuation of the inside of this optical unit 10 to generate a vacuum is described with reference to Fig. 2. Fig. 2 is a schematic structural diagram showing the evacuation device (such as a turbomolecular pump) fitted to the optical unit 10 shown in Fig. 1.

The first step in evacuating the inside of the optical unit 10 involves connecting a turbomolecular pump 21 to the gate valve 18 fitted to the X-ray inlet 16 of the airtight container 15. The gate valve 18 is then opened, and with the gate valve 19 closed, the turbomolecular pump 21 is used to evacuate the inside of the optical unit 10. At this time, the pressure inside the airtight container 15 is measured by a pressure gauge 22, and the evacuation speed is preferably regulated by a control system (not shown in the drawings) based on the measured pressure value. By adopting this type of evacuation procedure, the generation of sudden pressure differences within the optical unit 10 can be prevented, meaning deformation and positional displacement of the multilayer film mirrors caused by such pressure differences can be suppressed. Once the degree of vacuum inside the optical unit 10 has reached a predetermined value (for example, no more than 1x10⁻³ Pa), the gate valve 18 is closed and the turbomolecular pump 21 is disconnected. This enables the inside of the optical unit 10 to be maintained in a state of vacuum.

In this embodiment, the turbomolecular pump used for the evacuation is fitted to the gate valve at the X-ray inlet, but the pump could also be fitted to the gate valve at the X-ray outlet. Furthermore, the turbomolecular pump could also be fitted to another portion that is separate from both the gate valve at the X-ray inlet and the gate valve at the X-ray outlet. For example, the turbomolecular pump could also be fitted to a gate valve connected to an exhaust port used specifically for evacuating gas from inside the airtight container.

In this embodiment, gate valves are provided at the X-ray inlet and the like, but the present invention is not limited to this configuration, and any type of valve or opening mechanism can be used. Other suitable examples include ball valves and butterfly valves.

As described above, the inside of the optical unit 10 shown in Fig. 1 can be maintained in a state of vacuum, meaning the quantity of organic gas molecules that physically adsorb to the surfaces of the optical devices housed inside the optical unit can be reduced. In other words, the optical unit 10 enables contamination of the optical device surfaces to be suppressed.

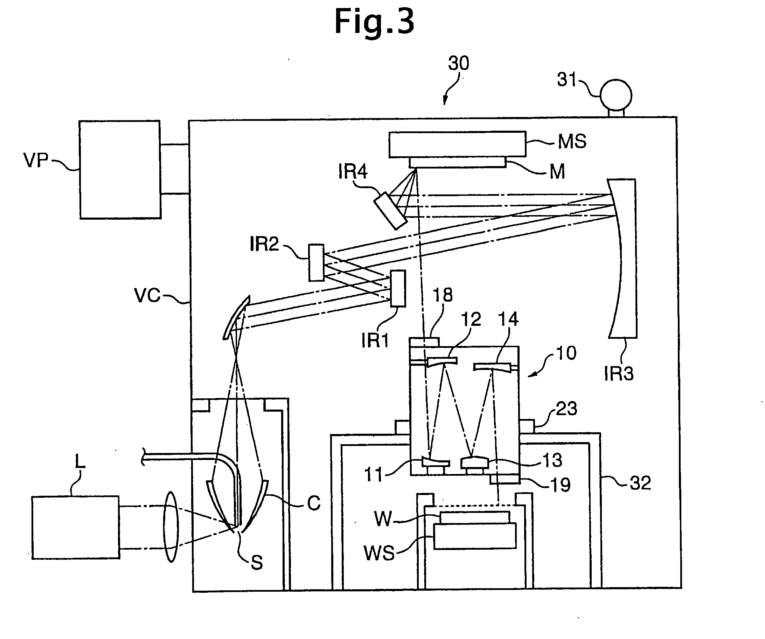

Next is a description of an X-ray exposure system that uses the optical unit shown in Fig. 1, with reference to Fig. 3. Fig. 3 is a schematic structural diagram showing an X-ray exposure system according to an embodiment of the present invention, using the optical unit shown in Fig. 1.

As shown in Fig. 3, the X-ray exposure system 30 includes, as its main components, an X-ray source S, a condenser C, an illumination optical system IR (comprising IR1, IR2, IR3, IR4, and the like), a stage MS for a mask M, an optical unit 10 including a projection optical system, a stage WS for a wafer W, a vacuum chamber VC, and an evacuation system VP. The optical unit 10 is installed in the X-ray exposure system 30 in the manner described below.

The procedure for installing the optical unit 10 in the X-ray exposure system 30 is as described below. First, with the inside of the optical unit 10 in a state of vacuum, a flange 23 on the outside surface of the optical unit 10 is secured to a mounting column 32 provided inside the X-ray exposure system 30. Then, in order to enable driving of the gate valves 18 and 19, piping for compressed gas (gas inlet and gas outlet piping; not shown in the drawing) is connected to each of the gate valves 18 and 19. Each set of compressed gas piping (not shown in the drawing) passes through the wall of the vacuum chamber VC and is attached to piping outside the vacuum chamber. The compressed gas uses either a rare gas such as helium (He), argon (Ar), krypton (Kr), or Xenon (Xe), or nitrogen (N₂) gas so that even if the gas leaks unintentionally into the vacuum chamber VC, it does not cause contamination. Evacuation of the inside of the vacuum chamber VC is then started, and once the degree of vacuum inside the vacuum chamber has reached a predetermined value (for example, no more than 1x10⁻³ Pa), the gate valves 18 and 19 are opened. By using this procedure, the inside of the optical unit 10 can be maintained in a state of vacuum during the assembly of the X-ray exposure system.

Following installation of the optical unit 10 in the X-ray exposure system 30, the exposure operation is commenced, and the pattern image formed on the mask M is projected onto the resist-coated wafer W. In the case of the X-ray exposure system 30 shown in Fig. 3, the X-ray source S may also use a discharge plasma source or some other form of irradiated light instead of the laser plasma source including the plasma excitation laser L The illumination optical system IR includes a grazing incidence mirror for reflecting the X-ray beam which strikes the mirror surface at an oblique angle, multilayer film mirrors in which the reflective surface is formed from a multilayer film, and a filter that allows the transmission of only X-rays of a predetermined wavelength. This illumination optical system enables the surface of the reflective mask M to be illuminated with an X-ray beam of a predetermined wavelength.

A projection optical system that is housed inside the optical unit 10 includes a plurality (4 in the case shown in Fig. 3) of multilayer film mirrors 11 to 14. The circuit pattern formed on the mask M is imaged onto the resist-coated wafer W by the projection optical system, and thus transferred to the resist. Because the X-rays are attenuated by atmospheric absorption, the exposure operation is conducted with the entire optical path housed inside the vacuum chamber VC. The inside of this vacuum chamber VC is maintained at a predetermined degree of vacuum by the evacuation system VP. This means that the inside of the optical unit 10 can be maintained under vacuum during the exposure operation.

In those cases where, following the completion of exposure for a predetermined period of time, the vacuum chamber VC needs to be opened to the atmosphere (leaked) to enable maintenance or the like of the X-ray exposure system 30, the gate valves 18 and 19 are first closed, and the inside of the vacuum chamber VC is then leaked. By using this procedure, the state of vacuum inside the optical unit 10 is maintained even when the vacuum chamber VC is leaked to enable maintenance or the like of the exposure system.

When the inside of the vacuum chamber VC undergoes either evacuation or leaking, the pressure inside the vacuum chamber VC is measured using a pressure gauge 31, and the evacuation speed or leak speed is preferably regulated by a control system (not shown in the drawings) based on the measured pressure value. By using this type of procedure, the generation of sudden pressure differences within the optical unit 10 can be prevented, meaning deformation and positional displacement of the multilayer film mirrors caused by such pressure differences can be suppressed.

As described above, with the X-ray exposure system 30 shown in Fig. 3, the optical unit 10 can be maintained in a state of vacuum during assembly of the exposure system, the exposure operation, and maintenance of the system, meaning the quantity of organic gas molecules that physically adsorb to the surfaces of the optical devices such as multilayer film mirrors housed inside the optical unit can be reduced. Furthermore, because the inside of the vacuum chamber VC is leaked under a state where the gate valves 18 and 19 have been closed, the fine particles that are stirred up inside the vacuum chamber VC during leaking of the X-ray exposure system 30 are prevented from entering the optical unit 10. In other words, contamination of the optical device surfaces inside the optical unit 10 can be suppressed.

In this embodiment, compressed gas is used for driving the gate valves, but the present invention is not limited to this configuration, and any system that enables remote operation of the opening and closing of the gate valves can be used. For example, if an electrically driven system is used, then the gas piping required in this embodiment becomes unnecessary, meaning the installation of the optical unit is simplified. Furthermore, ball valves, butterfly valves, or the like may also be used in place of the gate valves.

Furthermore, in this embodiment, only the multilayer film mirrors of the projection optical system are housed inside the optical unit 10, but a portion of the multilayer film mirrors that constitute the illumination optical system (the mirror IR4 for example) may also be housed inside the same optical unit 10. Because the optical system of the X-ray exposure system is a reflection-based system, the multilayer film mirrors of the projection optical system and the multilayer film mirrors of the illumination optical system are positioned in close proximity. As a result, it is possible to house both the projection optical system and a portion of the illumination optical system within the same optical unit, meaning contamination of the surfaces of a larger quantity of optical devices can be suppressed.

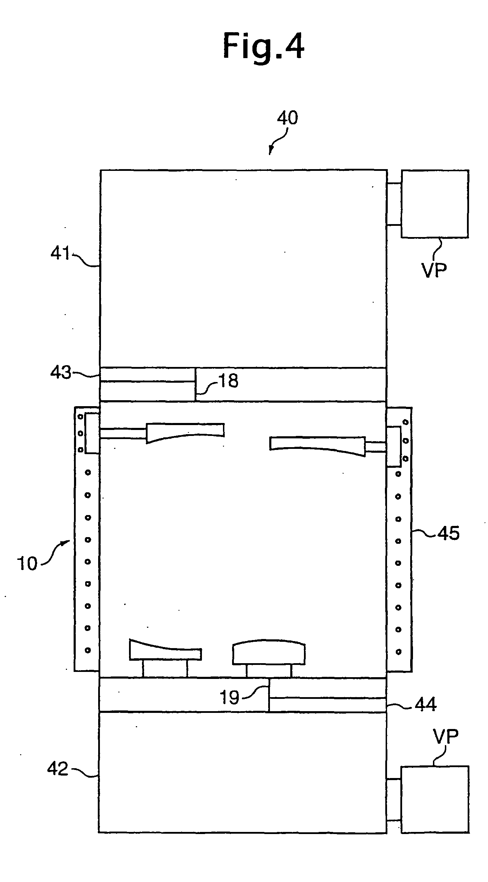

As follows is a description of a modified example of the X-ray exposure system 30 shown in Fig. 3, with reference to Fig. 4. Fig. 4 is a schematic structural diagram showing an X-ray exposure system according to another embodiment of the present invention, which uses the optical unit shown in Fig. 1.

The optical unit 10 of the X-ray exposure system 40 shown in Fig. 4 is not positioned within a vacuum chamber, but is rather located under normal atmospheric conditions. In the X-ray exposure system shown in Fig. 3, the optical unit is positioned inside a vacuum chamber, meaning any refrigerant or the like used for regulating the temperature of the optical unit from externally had to be introduced through the vacuum. As a result, the construction of the system becomes more complex, leading to increased production costs. In contrast, in the X-ray exposure system 40 shown in Fig. 4, the outside surface of the optical unit 10 is exposed to the atmosphere, meaning a thermoregulator 45 or the like can be installed under normal atmospheric conditions.

Specifically, the X-ray exposure system 40 includes a first vacuum chamber 41, an optical unit 10, a second vacuum chamber 42, and an evacuation system VP. The optical unit 10 is mounted on top of the lower second vacuum chamber 42, and the first vacuum chamber 41 is then mounted on top of the optical unit 10. A gate valve 43 is provided in the first vacuum chamber 41, and this gate valve 43 and the gate valve 18 of the optical unit 10 can be connected together. Furthermore, another gate valve 44 is provided in the second vacuum chamber 42, and this gate valve 44 and the gate valve 19 of the optical unit 10 can be connected together. Although not shown in the drawing, inside the first vacuum chamber 41 are provided an X-ray source, a condenser, an illumination optical system, a mask, a mask stage, and the like. Furthermore, inside the second vacuum chamber 42 are provided a wafer, a wafer stage, and the like. The evacuation system VP is able to evacuate the insides of the first vacuum chamber 41 and the second vacuum chamber 42 independently. A thermoregulator 45 such as refrigerant supply piping, which is used for cooling the mirrors and the like, is provided around the outside of the optical unit 10.

The first step required when installing the optical unit 10 within the X-ray exposure system 40 involves evacuating the insides of the first vacuum chamber 41, the optical unit 10, and the second vacuum chamber 42 down to a predetermined degree of vacuum (for example, no more than 1x10⁻³ Pa). The gate valve 18 and the gate valve 43 are then connected together, and the first vacuum chamber 41 is attached to the optical unit 10. Furthermore, the gate valve 19 and the gate valve 44 are also connected together, and the second vacuum chamber 42 is also attached to the optical unit 10. Following the interconnection of the first vacuum chamber 41, the optical unit 10, and the second vacuum chamber 42 in this manner, the gate valves 18, 19, 43 and 44 are all opened. Subsequently, with the evacuation system VP in operation, the exposure operation can be conducted with the X-ray optical path maintained at a predetermined degree of vacuum.

In this embodiment, the insides of the first vacuum chamber 41 and the second vacuum chamber 42 are evacuated down to a predetermined degree of vacuum prior to attachment to the optical unit 10, but the insides of the first vacuum chamber 41 and the second vacuum chamber 42 could also be evacuated following attachment of the two vacuum chambers 41 and 42 to the optical unit 10. In such a case, the gate valves 18, 19, 43, and 44 are only opened for exposure once the degree of vacuum inside each of the vacuum chambers 41 and 42 has reached the predetermined value.

In those cases where, following the completion of exposure for a predetermined period of time, the first vacuum chamber 41 and the second vacuum chamber 42 need to be leaked to enable maintenance or the like of the X-ray exposure system 40, the gate valves 18, 19, 43, and 44 are first closed, and the inside of each vacuum chamber is then leaked.

As described above, with the X-ray exposure system 40 shown in Fig. 4, the optical unit 10 can be maintained in a state of vacuum during assembly of the X-ray exposure system, the exposure operation, and maintenance of the system, meaning the quantity of organic gas molecules that physically adsorb to the surfaces of the optical devices such as multilayer film mirrors housed inside the optical unit can be reduced. In other words, the X-ray exposure system 40 enables contamination of the optical device surfaces to be suppressed. In addition, the thermoregulator 45 provided around the exterior of the optical unit 10 can be installed under normal atmospheric conditions, thus simplifying the construction of the optical unit and lowering the production costs.

As follows is a description of a modified example of the optical unit 10 shown in Fig. 1, with reference to Fig. 5. Fig. 5 is a schematic structural diagram showing an optical unit according to another embodiment of the present invention.

An optical unit 50 shown in Fig. 5 is provided with a mirror holding unit 61, which is connected to a series of mirror holding mechanisms 51a to 54a and is independent of the airtight container 55. When the optical unit 10 shown in Fig. 1 is evacuated down to a state of vacuum, the airtight container 15 distorts under the effect of atmospheric pressure, and even though each of the mirror holding mechanisms 11a to 14a connected to the airtight container 15 is provided with a cushioning mechanism, the multilayer film mirrors are still prone to deformation and positional displacement. Accordingly, in the optical unit 50 shown in Fig. 5, because the mirror holding unit 61 is independent of the airtight container 55, any distortion of the airtight container 55 is not transmitted to the mirror holding unit 61 that holds the mirrors.

Specifically, the optical unit 50 shown in Fig. 5 includes a plurality (4 in the case shown in Fig. 5) of multilayer film mirrors 51, 52, 53, and 54 that constitute the projection optical system. These multilayer film mirrors 51, 52, 53, and 54 are attached to the mirror holding unit 61 via a series of holding mechanisms 51a, 52a, 53a, and 54a, respectively. The mirror holding unit 61 is made of invar, and shows little expansion or contraction on temperature variation, meaning deformation or positional displacement of the mirrors is less likely to occur. The airtight container 55 covers the mirror holding unit 61, but does not contact the mirror holding unit 61.

The mirror holding unit 61 is connected to supports (platforms) 63 via a series of support members (legs) 62. The support members 62 are positioned equidistantly around the periphery (for example, 3 support members could be positioned at 120 degree intervals). Bellows 64 are provided around the periphery of the support members 62 in the spaces between the airtight container 55 and the supports 63. Each support member 62 passes through the center of the bellows 64 and is connected to the corresponding support 63 without physically contacting the bellows 64. Furthermore, the airtight container 55 is also connected to the supports 63 via a series of support members 65. The support members 65 are also positioned equidistantly around the periphery (for example, 3 support members could be positioned at 120 degree intervals). In order to ensure that the support members 62 and 65 do not interfere, they are offset by 60 degrees relative to each other. Furthermore, in order to minimize the level of out-gas expelled when the system is evacuated, the surfaces of the mirror holding unit 61 and the airtight container 55 are subjected to electrolytic polishing.

A gate valve 58 that is opened and closed using a cylinder mechanism driven by compressed gas is provided at the X-ray inlet 56 of the airtight container 55. Furthermore, a similar gate valve 59 that is also opened and closed using a cylinder mechanism driven by compressed gas is provided at the X-ray outlet 57 of the airtight container 55. This enables the inside of the optical unit 50 to be sealed in an airtight manner. Furthermore, an evacuation system (such as a turbomolecular pump) can be attached at the gate valve 58.

To place the inside of the optical unit 50 under a state of vacuum, the turbomolecular pump is first connected to the gate valve 58 attached to the X-ray inlet 56 of the airtight container 55. The gate valve 58 is then opened, and the turbomolecular pump is operated with the other gate valve 59 closed, thus evacuating the inside of the optical unit 50. Once the degree of vacuum inside the optical unit 50 has reached a predetermined value (for example, no more than 1x10⁻³ Pa), the gate valve 58 is closed and the turbomolecular pump is disconnected. This enables the inside of the optical unit 50 to be maintained in a state of vacuum.

As described above, even when the inside of the optical unit 50 is evacuated down to vacuum, in the present embodiment, the mirror holding unit 61 connected to the mirror holding mechanisms is provided independently of the airtight container 55, meaning any distortion of the airtight container 55 is not transmitted to the mirror holding unit 61 that holds the mirrors. As a result, this optical unit 50 is able to suppress deformation and positional displacement of the multilayer film mirrors.

The first step required when installing the optical unit 50 within the X-ray exposure system 30 involves attaching the supports 63 to a mounting column or the like (for example, see Fig. 3) provided inside the exposure system, with the inside of the optical unit 50 maintained in a state of vacuum. Then, in order to enable driving of the gate valves 58 and 59, piping for compressed gas (not shown in the drawing) is connected to each of the gate valves 58 and 59. Each set of compressed gas piping (not shown in the drawing) passes through the wall of the vacuum chamber VC of the exposure system and is attached to piping outside the vacuum chamber. The compressed gas uses either a rare gas such as He, Ar, Kr, or Xe, or N₂ gas so that even if the gas leaks unintentionally into the vacuum chamber, it does not cause contamination. Evacuation of the inside of the vacuum chamber is then started, and once the degree of vacuum inside the vacuum chamber has reached a predetermined level, the gate valves 58 and 59 are opened and the exposure operation is conducted.

In those cases where, following the completion of exposure for a predetermined period of time, the vacuum chamber VC needs to be opened to the atmosphere (leaked) to enable maintenance or the like of the X-ray exposure system, the gate valves 58 and 59 are first closed, and the inside of the vacuum chamber is then leaked.

As described above, with an X-ray exposure system that uses the optical unit 50 shown in Fig. 5, the optical unit 50 can be maintained in a state of vacuum during assembly of the exposure system, the exposure operation, and maintenance of the system, meaning the quantity of organic gas molecules that physically adsorb to the surfaces of the optical devices such as multilayer film mirrors housed inside the optical unit can be reduced. In other words, contamination of the optical device surfaces can be suppressed. In addition, because the optical unit 50 is constructed so that even when evacuated down to a state of vacuum, any distortion of the airtight container 55 is not transmitted to the mirror holding unit 61 that holds the mirrors, deformation and positional displacement of the multilayer film mirrors can be suppressed.

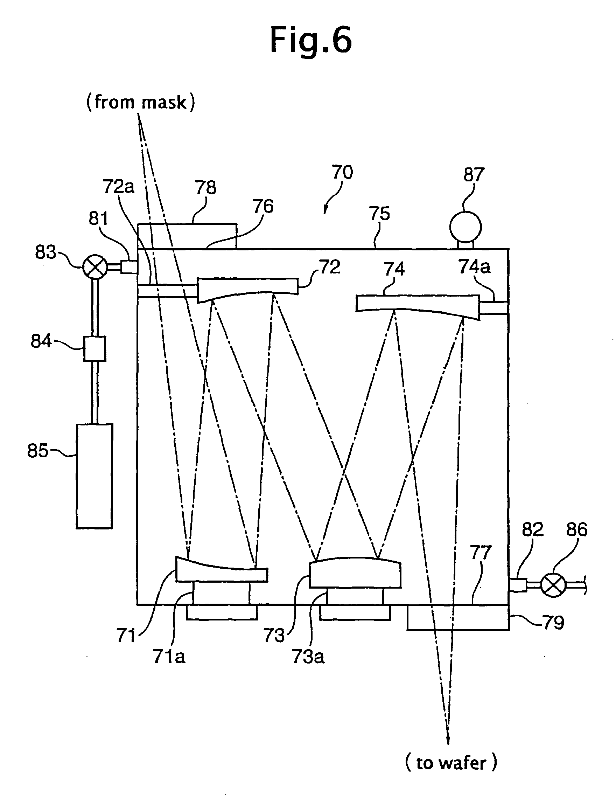

As follows is a description of a modified example of the optical unit 10 shown in Fig. 1, with reference to Fig. 6. Fig. 6 is a schematic structural diagram showing an optical unit according to yet another embodiment of the present invention. The inside of the optical unit 70 shown in Fig. 6 is not evacuated down to vacuum, but is rather filled with a clean displacement gas from which fine particulate matter and any organic materials that may cause mirror contamination have been removed.

Specifically, the optical unit 70 shown in Fig. 6 includes an airtight container 75 that houses a plurality (4 in the case shown in Fig. 6) of multilayer film mirrors 71, 72, 73, and 74 that constitute a projection optical system. The multilayer film mirrors 71, 72, 73, and 74 are attached to the airtight container 75 via holding mechanisms 71a, 72a, 73a, and 74a, respectively. The airtight container 75 is a substantially airtight structure, and provided the conductance between the inside and the outside of the container is lower than a certain level, a small amount of gas inflow and outflow is acceptable. An opening mechanism 78 is provided at the X-ray inlet 76 of the airtight container 75. Furthermore, an opening mechanism 79 is also provided at the X-ray outlet 77 of the airtight container 75. These opening mechanisms 78 and 79 may be electromagnetic shutters for example, and can be opened and closed using externally generated electrical signals.

The airtight container 75 is also provided with an inflow slot 81 and an outflow slot 82 for the displacement gas. A valve 83, a filter 84, and a displacement gas supply source (cylinder) 85 that are positioned outside the airtight container 75 are connected to the inflow slot 81 for the displacement gas via piping. The cylinder 85 contains high purity Ar, and the Ar gas discharged from the cylinder 85 passes through the filter 84 (for example, a fine particulate filter or a chemical filter) to remove impurities, and then flows through the valve 83 and into the airtight container 75. Furthermore, a valve 86 positioned outside the airtight container 75 is connected to the outflow slot 82. By opening this valve 86, the gas inside the airtight container 75 is expelled externally.

In order to replace the gas inside the optical unit 70 with clean Ar gas, the electromagnetic shutters (opening mechanisms) 78 and 79 are closed, and with the valves 83 and 86 open, high purity Ar gas is introduced into the optical unit 70. At this point, the pressure inside the airtight container 75 is measured using a pressure gauge 87, and the degree of opening of the valves 83 and 86 is regulated by a control system (not shown in the drawing) based on the measured pressure value, so that the pressure inside the airtight container 75 is either the same as, or slightly higher than, the outside pressure. This enables the gas inside the optical unit 70 to be replaced with a clean displacement gas containing no substances liable to cause contamination, and this state can then be maintained.

In this embodiment, Ar gas is used as the displacement gas, but the present invention is not limited to this case, and other rare gases such as He, Kr, or Xe, or N₂ gas could also be used. Furthermore, in a similar manner to that shown in Fig. 1, a thermoregulator such as a cooling jacket may also be provided around the exterior of the airtight container 75, thus enabling the temperature of the optical unit 70 to be held at a constant level.

As described above, the inside of the optical unit 70 shown in Fig. 6 is maintained under an atmosphere of a clean displacement gas, meaning the quantity of organic gas molecules that physically adsorb to the surfaces of the X-ray optical devices such as multilayer film mirrors housed inside the optical unit can be reduced. Accordingly, the optical unit 70 enables contamination of the optical device surfaces to be suppressed.

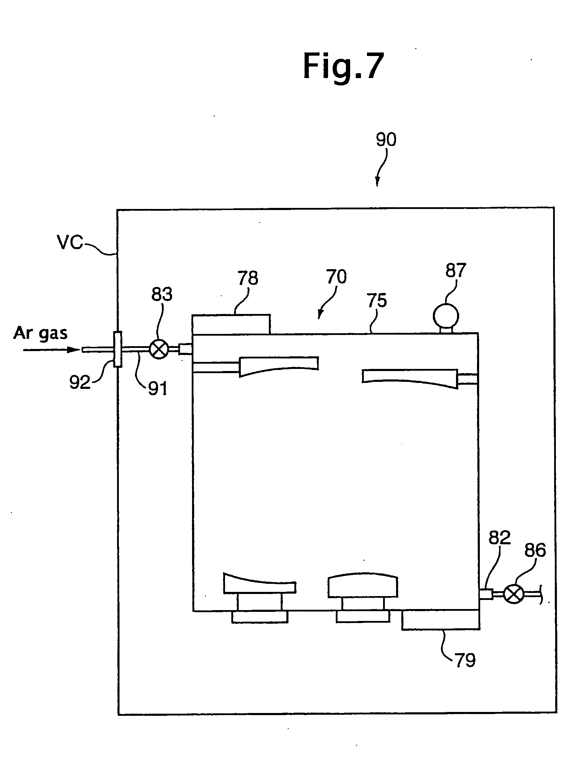

Next is a description of an X-ray exposure system that uses the optical unit shown in Fig. 6, with reference to Fig. 7. Fig. 7 is a schematic structural diagram showing the vicinity around the optical unit of an X-ray exposure system according to yet another embodiment of the present invention, which uses the optical unit shown in Fig. 6.

In order to incorporate the optical unit 70 within the X-ray exposure system 90, the optical unit 70 is first attached to a mounting column or the like (for example, see Fig. 3) provided inside the exposure system, with the inside of the optical unit 70 held under a clean displacement gas atmosphere. The valves 83 and 86 are then closed, and once the filter 84 and the cylinder 85 have been removed from the optical unit 70, a gas supply pipe 91 is attached to the valve 83. This gas supply pipe 91 is connected to a feed-through flange 92 provided in the vacuum chamber VC of the X-ray exposure system 90. A filter and a cylinder containing high purity Ar gas, which are provided outside the vacuum chamber VC, are connected to the feed-through flange 92 via piping, and this structure enables Ar gas, from which any impurities have been removed, to be supplied to the inside of the airtight container 75 via the valve 83. During supply of the Ar gas, the valves 83 and 86 are opened.

To evacuate the inside of the vacuum chamber VC down to vacuum, the valves 83 and 86 are closed, the electromagnetic shutters 78 and 79 are opened, and the Ar gas inside the optical unit 70 is expelled. This means that a pressure difference between the inside and the outside of the optical unit 70 can be prevented from developing. Once the degree of vacuum inside the vacuum chamber VC has reached a predetermined value (for example, no more than 1x10⁻³ Pa), the exposure operation is conducted.

In those cases where, following the completion of exposure for a predetermined period of time, the vacuum chamber VC needs to be leaked to enable maintenance or the like of the X-ray exposure system, the electromagnetic shutters 78 and 79 are first closed, and the inside of the vacuum chamber VC is then leaked. At this point, the pressure inside the airtight container 75 is measured by the pressure gauge 87, and the pressure inside the vacuum chamber VC is measured by another pressure gauge (not shown in the drawing), and the degree of opening of the valves 83 and 86, and the quantity of gas introduced into the vacuum chamber VC are regulated by a control system based on these measured pressure values, so that high purity Ar gas can be introduced without generating a pressure difference between the inside and the outside of the airtight container 75. Once leaking of the vacuum chamber VC has been completed, the pressure inside the airtight container 75 is either the same as, or slightly higher than, the outside pressure.

As described above, with the X-ray exposure system 90 shown in Fig. 7, the optical unit 70 is maintained under an atmosphere of a clean displacement gas during assembly and maintenance of the X-ray exposure system, meaning the quantity of organic gas molecules that physically adsorb to the surfaces of the X-ray optical devices such as multilayer film mirrors housed inside the optical unit can be reduced. Furthermore, because the inside of the vacuum chamber VC is leaked under a state where the electromagnetic shutters 78 and 79 have been closed, the fine particles that are stirred up inside the chamber during leaking are prevented from entering the optical unit 70. In other words, the X-ray exposure system 90 enables contamination of the optical device surfaces to be suppressed. Furthermore, when the inside of the vacuum chamber VC is evacuated, the inside of the optical unit 70 is also evacuated, meaning the exposure operation can be conducted in the normal manner.

In this embodiment, an outflow slot 82 is provided to allow the gas inside the airtight container 75 to flow out, but an outflow slot need not necessarily be provided, provided gas is able to flow out through the electromagnetic shutters 78 and 79 or another opening in the airtight container 75.

Furthermore, in those cases where deformation or positional displacement of a multilayer film mirror occurs due to a small pressure difference between the inside and the outside of the airtight container 75, a mirror holding unit is preferably provided independently of the airtight container, in a similar manner to the optical unit 50 shown in Fig. 5. In such cases, the inflow and outflow slots for the displacement gas, a pressure gauge, and the electromagnetic shutters are provided within the outer airtight container. The electromagnetic shutters are preferably formed from members that are transparent to ultraviolet light or visible light. This allows positional adjustment of the optical system such as the mirrors to be conducted using a simple ultraviolet or visible light laser beam, with the inside of the optical unit containing the clean displacement gas.

Optical units according to embodiments of the present invention, and X-ray exposure systems using such optical units have been described above, but the present invention is not limited to these embodiments, and various modifications are possible.

### EFFECT OF THE INVENTION

As described above, according to an optical unit and an X-ray exposure system of the present invention, the quantity of organic gas molecules that physically adsorb to the surfaces of the optical devices such as multilayer film mirrors housed inside the optical unit can be reduced during assembly of the X-ray exposure system, the exposure operation, and maintenance of the system. Accordingly, contamination of the optical device surfaces can be suppressed. As a result, deterioration in the reflectance of the optical devices, and deterioration in the throughput of the exposure system can be suppressed.

## Claims

1. An optical unit comprising:
an X-ray optical device;
an airtight container housing said X-ray optical device in an airtight state; and
valves or openable and closable opening mechanisms which are attached to an X-ray inlet and an X-ray outlet of said airtight container.

2. An optical unit comprising:
an X-ray optical device;
a holding unit holding said X-ray optical device;
an airtight container housing said X-ray optical device and said holding unit in an airtight state; and
valves or openable and closable opening mechanisms which are attached to an X-ray inlet and an X-ray outlet of said airtight container, wherein
any distortion of said airtight container is prevented from being transmitted to said holding unit.

3. The optical unit according to Claim 1 or 2, wherein
said valves or openable and closable opening mechanisms are composed of members that are transparent to ultraviolet light or visible light.

4. The optical unit according to Claims 1 to 3, wherein
said airtight container is provided with an exhaust port evacuating gas from inside the airtight container, and a valve or openable and closable opening mechanism connected to this exhaust port.

5. The optical unit according to any one of Claims 1 to 4, wherein
the inside of said airtight container is held under vacuum or a clean displacement gas atmosphere.

6. The optical unit according to any one of Claims 1 to 5, further comprising a position adjusting mechanism adjusting the position and orientation of the X-ray optical device from outside the airtight container under normal atmospheric conditions.

7. The optical unit according to any one of Claims 1 to 6, wherein
said X-ray optical device is an X-ray optical device that constitutes a projection optical system projecting a pattern image formed on a mask onto a photosensitive substrate.

8. The optical unit according to Claim 7, wherein
said X-ray optical device further includes a portion of an X-ray optical device that constitutes an illumination optical system irradiating X-rays from an X-ray source onto the mask.

9. The optical unit according to any one of Claims I to 8, wherein
said airtight container has a substantially airtight structure.

10. The optical unit according to any one of Claims 1 to 9, wherein
said airtight container is further provided with a thermoregulator.

11. An X-ray exposure system comprising:
an X-ray source generating X-rays;
an illumination optical system irradiating X-rays from the X-ray source onto a mask; and
an optical unit that houses an X-ray optical device which constitutes a projection optical system projecting a pattern image formed on the mask onto a photosensitive substrate, wherein
said optical unit includes an airtight container housing the X-ray optical device in an airtight state, and an X-ray inlet and an X-ray outlet of said airtight container are provided with valves or openable and closable opening mechanisms.

12. An X-ray exposure system comprising:
an X-ray source generating X-rays;
an illumination optical system irradiating X-rays from the X-ray source onto a mask; and
an optical unit that houses an X-ray optical device which constitutes a projection optical system projecting a pattern image formed on the mask onto a photosensitive substrate, wherein
said optical unit includes a holding unit holding the X-ray optical device and an airtight container housing the X-ray optical device and the holding unit in an airtight state, and an X-ray inlet and an X-ray outlet of said airtight container are provided with valves or openable and closable opening mechanisms.
